# EUROPEAN PATENT SPECIFICATION

(11) **EP 3 151 644 B1**
(45) Date of publication and mention of the grant of the patent: **12.06.2019**
(21) Application number: 16191212.6
(22) Date of filing: 28.09.2016
(51) Int. Cl.: H05K 7/14, G06F 1/18, H05K 1/14

(54) **GUIDE AND SUPPORT APPARATUS FOR PRINTED CIRCUIT BOARD**
FÜHRUNGS- UND UNTERSTÜTZUNGSVORRICHTUNG FÜR LEITERPLATTEN
GUIDE ET DISPOSITIF DE SUPPORT POUR CARTE DE CIRCUITS IMPRIMÉS

(30) Priority: 30.09.2015 WO PCT/CN2015/091180
(43) Date of publication of application: 05.04.2017
(73) Proprietor: Honeywell International Inc., Morris Plains, NJ 07950 (US)
(72) Inventor: PENG, Wen, Morris Plains, NJ 07950 (US); LIU, Chaohong, Morris Plains, NJ 07950 (US); JIANG, Lei, Morris Plains, NJ 07950 (US)
(74) Representative: Houghton, Mark Phillip

(56) References cited:
- US-A- 3 932 016
- US-A- 4 894 753
- US-A- 4 951 176
- US-A- 5 726 865
- US-A- 5 980 295
- US-A1- 2007 258 195

## Description

### TECHNICAL FIELD

Embodiments described herein generally relate to a support apparatus for electronic device, and more particularly, to a guide and support apparatus for printed circuit board.

### BACKGROUND

In electronic devices, a printed circuit board is usually employed to carry various electronic components for carrying out several functions. The component density now is becoming higher and higher in order to achieve more functions with less space. This requires the mechanical structure to be compact and efficient. To this end, the different portions of the printed circuit board are modularized and connected together perpendicularly.

U.S. Patent No. 3,932,016 discloses a printed circuit card receptacle that is formed of one or more edge connectors having a pair of opposed, slotted card guides affixed thereto. The receptacle includes a mountable connector having a channel member at either end thereof for receiving the guide. Each card guide has a sleeve portion for slideably engaging the channel member and a releaseable locking means for holding the card guide affixed in place after full engagement of the sleeve with the channel member. The receptacle includes means for holding the printed circuit card in the connector.

U.S. Patent No. 5,980,295 discloses an electrical connector for reliably and electrically connecting a daughter board and a mother board. The electrical connector includes a first housing, a second housing, and a pair of board retaining means. The second housing is integrally formed with two opposed supporting portions, which each further has a pair of spaced guiding rails for respectively guiding and clamping two opposed edges of the daughter board. A cavity portion is defined with a horizontal cavity and a vertical cavity. Each board retaining means is defined with an acting portion, a first resilient portion, a latching portion, a second resilient portion, and a retentive portion for efficiently locking the inserted daughter board to maintain a reliable electrical contact between the daughter board and the electrical connector.

U.S. Patent No. 5,726,865 discloses an apparatus for retaining a circuit board in a connected position. The apparatus is constituted with at least a first retention arm and a first clip that cooperate with each other and with a first edge of the circuit board to securely retain the first edge. The first retention arm includes a first end that is geometrically shaped to allow the first clip to slide onto the first end and slide towards the first edge. The first edge and the first clip further include first complementary engagement features for the first clip to engage the first edge when the first slip slide up against the first edge. Furthermore, the first end includes a deflectable stop lever that can be depressed to allow the first clip to slide over it, and then be released to snugly engage a first notch of the first clip to keep the first clip from sliding back off the first end.

U.S. Patent Publication No. 2007/0258195 discloses a fastening assembly for riser cards equipped with memory modules that includes holders and latches. Each of the holders has bars and pillars to form a solid framework and couple to a mother board. The edges of the riser cards are held by holding grooves on the pillars to enable the riser cards sliding therein and insert towards riser sockets on the mother board. Meanwhile, the latches slip to latch the holding grooves to limit the movement of the riser cards. Thus, the fastening assembly improves the fixing strength of the riser cards and prevents from moving off while impacted, vibrated or crashed.

U.S. Patent Publication No. 4951176 describes an apparatus for supporting electronic components. It has a rectangular base plate formed with openings for the terminal lugs or spades. Two holder arms extend from the narrow sides of the base plate, each having module support portions extending in a first direction and a retention post extending in a second opposite direction. The extension post is insertable into openings of the receiving printed circuit board.

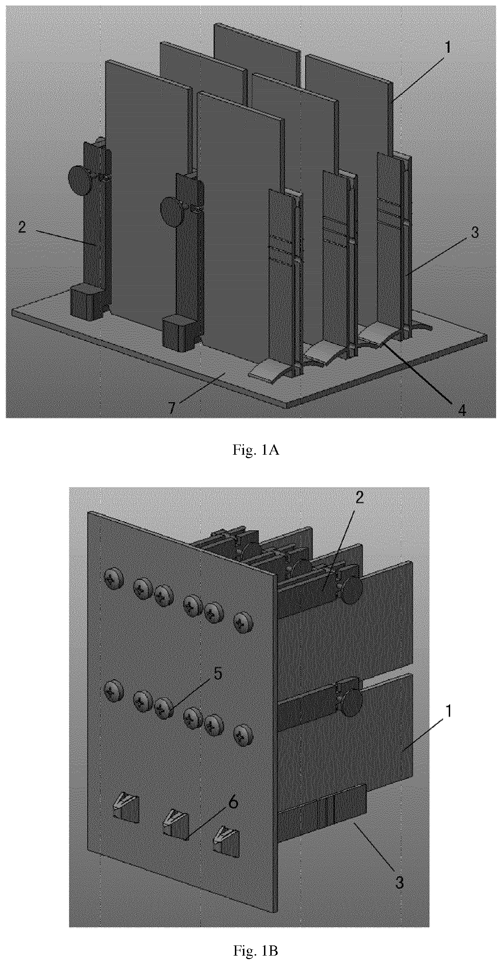

Figure 1A and 1B show an assembled printed circuit board in the prior art. Several child boards 1 are held on the mother board 7 by guide rails 2 and 3. As shown in figure 1A and 1B, the guide rails 2 are placed perpendicularly to front side of the mother board 7 and fixed by screws 5 on the opposed back side of the mother board 7. The guide rails 3 are mounted perpendicularly on the mother board 7 with its lock head 6 passing through the holes of the mother board 7 to the back side and the lock wings 4 against the front side. The child boards 1 are supported and locked between two guide rails 2, two guide rails 3 or one guide rails 2 and one guild rail 3. In this way, it is easy for the child board 1 to be mounted on the mother board 7 and occupy less space.

However, in the case where the mother board carries many child boards and has a lot of electronic components to be mounted thereon, the existing guide and support structure cannot meet the high density requirement.

Therefore, there is a need for an improved guide and support apparatus which saves more space and is easy to use.

### SUMMARY

The present invention in its various aspects is as set out in the appended claims

In one embodiment, a guide and support apparatus is provided. The guide and support apparatus comprise: a mounting portion, a support portion and a guide & lock portion, wherein the support portion extending perpendicularly to the guide & lock portion and ended at the mounting portion; the mounting portion extends downward from one or two ends of the support portion and comprises a lock structure; and the guide & lock portion extends from the support portion vertically to a certain height.

In another embodiment, a further guide and support apparatus is provided. The guide and support apparatus comprise: a support portion and a guide & lock portion, the guide & lock portion extends from the support portion vertically to a certain height, wherein the guide & lock portion includes first and second guide & lock portions. The guide & lock portion comprises two ribs which extend up to a certain height from the support portion and connected by a lock portion on their top end. A slot extends between the two ribs and ends with the lock portion. The lock portion is positioned between the two ribs, and has a top surface and a front surface. Two projections are formed next to the lock portion such that a groove is defined by the front surface of the lock portion and the two projections. The top surface of the lock portion is inclined relative to the front side of the ribs.

In another embodiment, a board matrix is provided. The board matrix comprises a child board, a mother board, and the guide and support apparatus according to above embodiment.

In another embodiment, a method for manufacturing a guide and support apparatus is provided. The method comprises forming a support portion; forming a guide and lock portion which extends from the support portion to a certain height; and forming a mounting portion. The support portion extending perpendicularly to the guide and lock portion and ended at the mounting portion. The mounting portion extends downward from one or two ends of the support portion and comprises a lock structure. The lock structure is below the support portion.

### DRAWINGS

Understanding that the drawings depict only exemplary embodiments and are not therefore to be considered limiting in scope, the exemplary embodiments will be described with additional specificity and detail through the use of the accompanying drawings, in which:
Figure 1A and 1B show an assembled printed circuit board in accordance with the prior art;
Figure 2A shows an example embodiment of a guide and support apparatus according to the disclosure;
Figure 2B shows another embodiment of a guide and support apparatus according to the disclosure;
Figure 3 shows the enlarged drawing of the guide & lock portion in figure 2A and 2B, according to the disclosure;
Figure 4 shows an example process for mounting the guide and support apparatus onto the mother board 40 which is a printed circuit board, according to the disclosure.
Figure 5A shows an example process for mounting the child board 51 into the guide and support apparatus 20 according to the disclosure;
Figure 5B shows a perspective diagram of the assembled board matrix according to the disclosure;
Figure 6 shows a perspective diagram of another board matrix according to the disclosure;
Figure 7A shows a perspective diagram of the assembled board matrix viewed from the front side according to the disclosure;
Figure 7B shows another perspective diagram of the assembled board matrix viewed from the back side according to the disclosure.
Figure 8A and 8B show another embodiment of the board matrix for the child boards with different width according to the disclosure; and
Figure 9 is a photo of the board matrix in a completed product according to the disclosure.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

As used herein, the terms "having", "containing", "including", "comprising" and the like are open ended terms that indicate the presence of stated elements or features but do not preclude additional elements or features. The articles "a", "an" and "the" are intended to include the plural as well as the singular, unless the context clearly indicates otherwise.

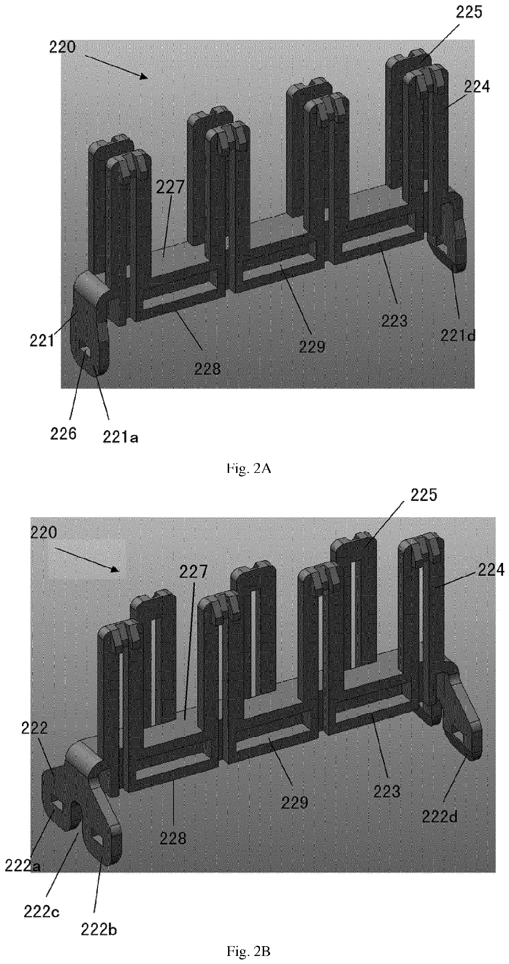

Figure 2A shows an example embodiment of a guide and support apparatus 220 according to the disclosure. The guide and support apparatus 220 includes a mounting portion 221, a support portion 223 and a guide & lock portion 224, 225. The support portion 223 extends perpendicularly to the guide & lock portion 224, 225 and is ended with the mounting portion 221. The support portion 223 includes top surface 227 and bottom surface 228 (not shown).

The mounting portions 221 extend downward from one or two ends where the support portion 223 is ended. The mounting portions 221 may be angled relative to the top surface 227 and bottom surface 228, and preferably, perpendicular to the top surface 227 and bottom surface 228. The mounting portion 221 includes a foot 221a, and a hole 226 is formed in the foot 221a. The level of the hole 226 is below the bottom surface of the support portion 223, i.e. the peak in hole 226 is below the bottom surface of the support portion 223, such that there is a space formed between the support portion 223 and an upper side of a mother board, i.e. the support portion 223 does not contact the mother board, when the guide and support apparatus 220 is mounted on the mother board. The mounting portion 221 can be flat and the holes 226 formed in foot 221a of the mounting portions 221 extending from the different end of the support portion 223 face to each other, and preferably, aligned with each other. The inner side at the bottom of the foot 221a can be cutoff partly to form a slope face 221d. The hole 226 can be shaped as rectangle, square, circle, ellipse, triangle, or any other suitable shape. The person skilled in the art should realize from above description that two or more holes which are located at the same level or different level can be formed in one foot, although only one hole 226 is shown in each foot.

There are several concaves 229 on the front side and the back side of the support portion 223 to strengthen the support portion 223 and to reduce the weight of the structure.

The guide &lock portion includes one or more first guide &lock portion 224 and one or more second guide &lock portion 225, for example, preferably, four first guide &lock portion 224 and four second guide &lock portion 225 in this embodiment, which all extend from the bottom surface 228 through the top surface 227 up to a certain height. As seen in figure 2A, the first guide &lock portion 224 is located on the front side and second guide &lock portion 225 is located on the back side of the support portion 223. The two kinds of guide &lock portion 224 and 225 are back to back, parallel and aligned with each other. The inner sides at the bottom of the foot 221a can be cut off partly to form a slope face 221d. There are guide and lock structure facing outward on the guide &lock portion, as described below. The concaves 229 are formed between two adjacent guide &lock portions along each side of the support portion 223.

The mounting portion 221, the support portion 223 and the guide & lock portion 224, 225 may be separate parts which can be assembled together by screw, pressing fit or snapping fit, or they can be integral. Some or all of the mounting portion 221, the support portion 223 and the guide & lock portion 224, 225 can be manufactured by injection molding, machining, bending or any other manufacturing process that can form the structure from any suitable material, such as plastic, sheet metal, and so on.

Figure 2B shows another embodiment of a guide and support apparatus 220 according to the disclosure. As seen in figure 2B, the guide and support apparatus 220 includes a mounting portion 222, a support portion 223 and a guide & lock portion 224, 225. The support portion 223 extends perpendicularly to the guide & lock portion 224, 225 and is ended with the mounting portion 222. The support portion 223 includes top surface 227 and bottom surface 228 (not shown).

The mounting portions 222 extend downward from one or two ends where the support portion 223 is ended. The mounting portions 222 may be angled relative to the top surface 227 and bottom surface 228, and preferably, perpendicular to the top surface 227 and bottom surface 228. The mounting portion 222 includes two feet 222a and 222b which are separated by a slot 222c. A hole 226 is formed in each of the feet 222a and 222b. As shown in figure 2B, the holes 226 formed in different feet are located at the same level which are below the bottom surface of the support portion 223 such that there is a space formed between the support portion 223 and a upper side of a mother board when the guide and support apparatus 220 is mounted onto the mother board. The mounting portion 222 can be flat and the holes 226 formed in foot 222a and 222b of the mounting portions 222 extending from the different end of the support portion 223 face to each other, and preferably, aligned with each other. The hole 226 can be shaped as rectangle, square, circle, ellipse, triangle, or any other suitable shape. The person skilled in the art should realize from above description that two or more holes which are located at the same level or different level can be formed in one foot, although only one hole 226 is shown in each foot.

There are several concaves 229 on the front side and the back side of the support portion 223 to strengthen the support portion 223 and to reduce the weight of the structure.

The guide &lock portion includes one or more first guide &lock portion 224 and one or more second guide &lock portion 225, for example, preferably, four first guide &lock portion 224 and three second guide &lock portion 225 in this embodiment, which all extend from the bottom surface 228 through the top surface 227 up to a certain height. As seen in figure 2B, the first guide &lock portion 224 is located on the front side and second guide &lock portion 225 is located on the back side of the support portion 223. The two kinds of guide &lock portion 224 and 225 are arranged to be back to back, parallel, and interleaved but not aligned with each other. There are guide and lock structure facing outward on the guide &lock portion 224 and 225, as described below. The concaves 229 are formed between two adjacent guide &lock portions along each side of the support portion 223, or between the guide &lock portion and the end of the support portion 223.

Similarly to the structure in figure 2A, the mounting portion 222, the support portion 223 and the guide & lock portion 224, 225 in figure 2B may be discrete components which can be assembled together, or they can be integral. Some or all of the mounting portion 222, the support portion 223 and the guide & lock portion 224, 225 can be manufactured by injection molding, machining, bending or any other manufacturing process that can form the structure from any suitable material, such as plastic, sheet metal, and so on.

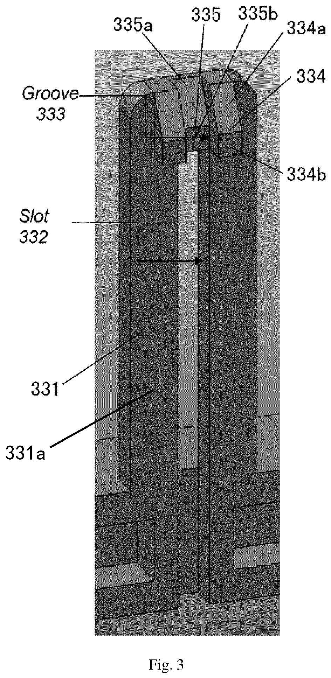

Figure 3 shows the enlarged drawing of the guide & lock portion 224 and 225 in figure 2A and 2B, according to the disclosure. As shown in figure 3, the guide & lock portion comprises two ribs 331 which extend up to a certain height from the top surface of the support portion 223 and connected by a lock portion 335 on their top end. The two ribs 331 may be parallel to each other and a slot 332 is formed between them. The slot 332 extends downward to the bottom surface of the support portion and upward to the lock portion 335.

The lock portion 335 is positioned between the two ribs 331 and has a top surface 335a and a front surface 335b. The top surface 335a may be inclined relative to the front side 331a of ribs 331 such that a child board can be guided into the slot 332 via the inclined top surface 335a and locked easily. In one embodiment, the top surface 335b may flush with the front side 331a of rib 331. In another embodiment, the top surface 335b may be parallel to and lower than the front side 331a of rib 331 such that the child board is limited in the slot 332 when it is assembled.

A projection 334 is formed on the top of each rib 331. As shown in figure 3, the projection 334 is located on the front side 331a and next to the lock portion 335. The projection 334 has a top surface 334a and a front surface 334b. The top surface 334a may be inclined relative to the front side 331a of ribs 331 and the top surface 334b may be parallel to the front side 331a of rib 331. The projections 334 on each rib 331 are paired. A groove 333 is defined by the lock portion 335 and a pair of projections 334 which is used to guide the child board. The guide and lock structure is constituted of the lock portion 335, the projection 334, the groove 333 and the slot 332.

The person skilled in the art should realize that two or more lock portion 335 can be formed between the two ribs and two or more pairs of projections 334 can be formed on the front side 331a of the rib 331, although only one block portion 335 and one pair of projections 334 are shown. Further, in one embodiment, in the case that the top surface 335b of lock portion 335 may be lower than the front side 331a of rib 331, the pair of projections 334 is not necessary. The person skilled in the art should realize that other structures which can achieve the similar function to the guide & lock portion in figure 3, existing or developed later, can be used.

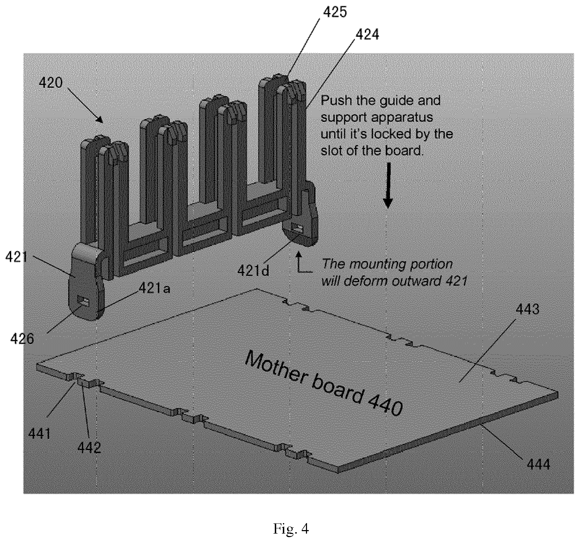

Figure 4 shows an example process for mounting the guide and support apparatus 420 onto the mother board 440 which is a printed circuit board, according to the disclosure. As shown in figure 4, several slots 441 are formed at both right and left edges of the mother board 440 by cutting off some material from the mother board. The size of the slot 441 corresponds to that of the foot 421a of the mounting portion 421. A convex 442 is formed in each slot 441, preferably, in the middle of the slot 441. The size of the convex 442 is matched with that of the hole 426 in foot 421a of the mounting portion 421. The slots 441 and convexes 442 at both edges of the mother board 440 may be formed symmetrically.

In order to mount the guide and support apparatus 420 onto the mother board 440, firstly, the guide and support apparatus 420 is located to make the guide & lock portions 424, 425 perpendicular to the mother board 440 and the mounting portion 421 aligned with the slot 441 substantially. Then, the guide and support apparatus 420 is moved toward the mother board 440 until the foot 421a of the mounting portion 421 contacts the convex 442 on the slot 441. After that, the mounting portion 421 will be deformed outward elastically, for example, by a force applied onto slope face 421d.

Next, the guide and support apparatus 420 continues to move toward the mother board until the convexes 442 are inserted into the holes 426 of the mounting portion 421. As such, the guide and support apparatus 420 is mounted and locked onto the mother board 440 vertically. The others guide and support apparatus 420 can be mounted onto the mother board 40 in a similar way.

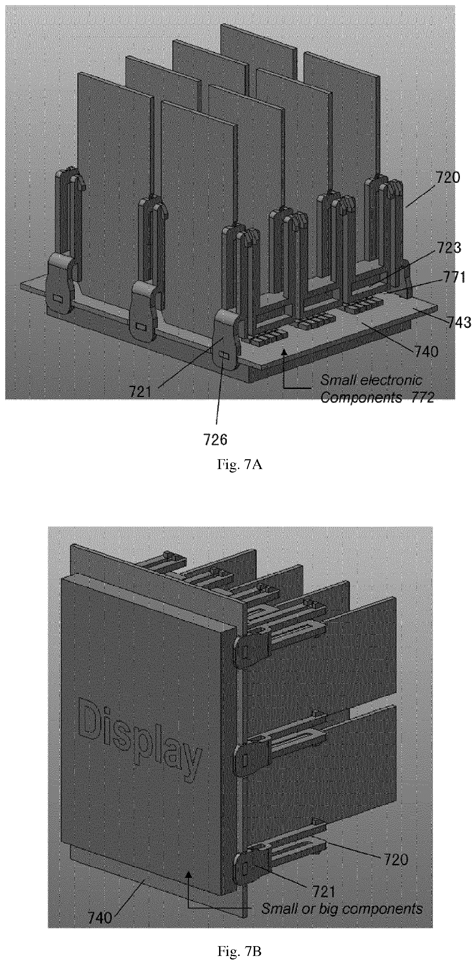

In this way, the guide and support apparatus 420 is mounted on mother board 440 without use of screws 5 and the lock head 6 on the back side, as depicted in figure 1A and 1B. Further, there are spaces formed between the bottom surface 428 of the support portion 423 and the upper side 443 of the mother board 440 because the level of the hole 426 is below the bottom surface of the support portion 423, as described in figure 2A. Therefore, the upper side and the back side both are not occupied by the guide and support apparatus 420. Thus, the upper side and the back side can be used to carry more electronic component on the mother board, as depicted in figure 7A and 7B.

In another embodiment, alternatively, instead of slot 441 and convex 442 both formed at the both edges of mother board, only convex 442 projects from the both edges. The size of the convex 442 is matched with that of the hole 426 in foot 221a of the mounting portion 421 and convexes 442 at both edges of the mother board 440 may be formed symmetrically.

Although the convex 442 and the hole 426 is used to lock and support the guide and support apparatus 420, the person skilled in the art should realize that some other locking and supporting structure can be used, as long as they can realize the similar effect.

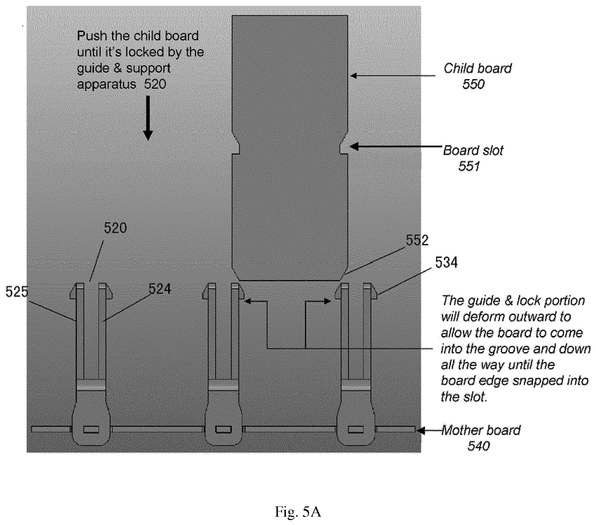

Figure 5A shows an example process for mounting the child board 551 into the guide and support apparatus 520 according to the disclosure. Three guide and support apparatuses 520 are mounted onto the motherboard 540 vertically. They are spaced apart by a distance and their respective guide and lock structures are faced and aligned. As shown in figure 5A, a child board 550 is located above the mother board 540 and aligned with the space between two adjacent guide and support apparatuses 520. Two board slots 551 may be formed at left and right edges of the child board 550 to be locked with the lock portion 335, as shown in figure 3. The lower left corner and right corners of the child board 550 may be cut off to form respective slope structures 552 which match the top surface 335a of the lock portion 335, also as shown in figure 3.

When mounting the child board 550, firstly, the child board 550 is moved downward such that the slope structure 552 contacts the top surface 335a of the lock portion 335. Then, the board is pushed to make the guide & lock portions 524 and 525 deformed outward to allow the child board to come into the groove 333, as depicted in figure 3. the child board 550 keeps moving downward until the lock portion 335 comes into the board slot 551 where the board edge of the child board 550 snap into the slot 332 and the child board 550 is locked by the guide & support portions 524 and 525. The others child board 550 can be mounted onto the guide & lock portions 524 and 525 in a similar way. A board matrix may be formed which includes a mother board 540, one or more guide and support apparatuses 520 and a plurality of child boards 550 when all the child boards 550 are mounted in place.

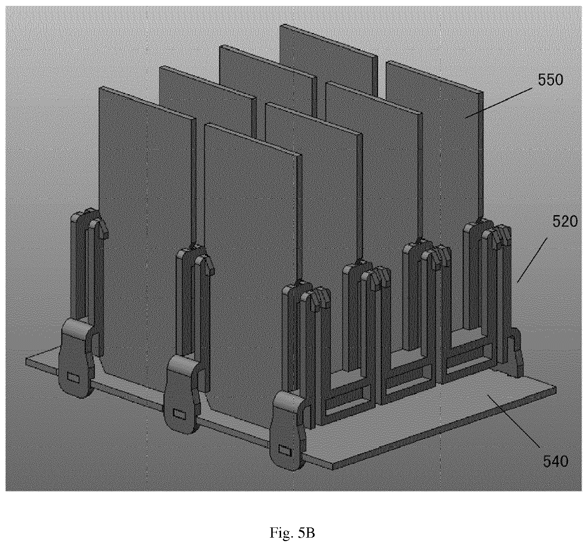

Figure 5B shows a perspective diagram of the assembled board matrix according to the disclosure. As shown in figure 5B, three guide and support apparatuses 520 are mounted on the mother board 540, each guide and support apparatuses 520 including four first guide & support portions 524 and four first guide & support portions 525. In that case, eight child boards 550 can be mounted on one mother board 540. As seen from figures, all the guide and support apparatuses 520 and child boards 550 can be assembled easily, thus a compact and flexible design for board matrix is achieved.

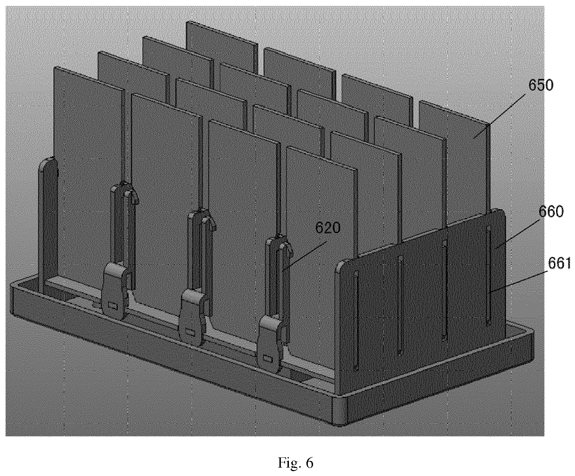

Figure 6 shows a perspective diagram of another board matrix according to the disclosure. As shown in figure 6, two covers 660 which are parallel to the guide and support apparatus 620 are provided at the edge of mother board 660. Several trenches 661 are formed by cutting off some material from the cover 660. When mounted to the edge of the mother board 640, the trenches 661 are parallel to and aligned with the slot 332 on the guide & lock portion 224, as shown in figure 3. The child board 650 can be inserted between the guide and support apparatus 620 and the cover 660, and is locked by trench 661. By use of the cover 660, more child boards 650 can be mounted onto the mother board 640. Thus an even higher density design for electronic devices is archived. The cover 660 can be made of plastic, sheet metal or any suitable material.

Figure 7A shows a perspective diagram of the assembled board matrix viewed from the front side according to the disclosure. As seen from figure 7A, there is a space 771 formed between the support portion 723 of the guide and support apparatus 720 and an upper side 743 of a mother board 740 because the level of the hole 726 in mounting portion 721 is below the bottom surface of the support portion 723. A plurality of electronic components 772 can be mounted just under the guide and support apparatus.

Figure 7B shows another perspective diagram of the assembled board matrix viewed from the back side according to the disclosure. As seen from figure 7B, the guide and support apparatus 720 is mounted onto the mother board 740 via mounting portion 721 at the both edges of the mother board 740 without use of screws 5 and the lock heads 6 (as depicted in figure 1) on the back side of the mother board 740. In other words, the back side of the mother board 740 is not occupied by any lock elements. Therefore, the space on the back side is also available for electronic components, for example, a relative big display screen. By this way, the mother board 740 can carry many child boards and have a lot of electronic components to be mounted thereon.

As seen from figures 5-7, all the child boards mounted between two adjacent guide and support apparatuses must have the same width. However, in some case, multiple child boards with different width need to be mounted between two adjacent guide and support apparatuses. The solutions in figures 5-7 can not meet this requirement.

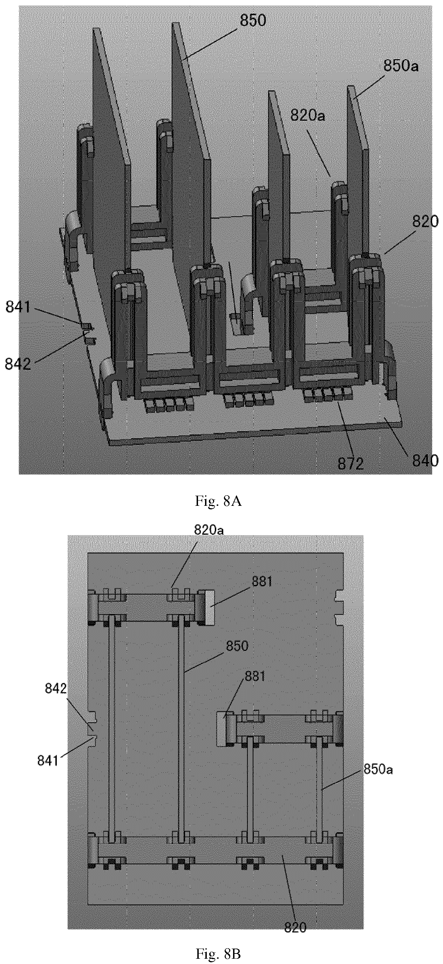

Figure 8A and 8B show another embodiment of the board matrix for the child boards with different width according to the disclosure. Figure 8A is a perspective diagram of the assembled board matrix, and figure 8B is a top view of the assembled board matrix. As shown, the child boards 850 and 850a are different in width. Accordingly, the guide and support apparatuses 820 and 820a may be of different length. The length of the guide and support apparatuses 820 and 820a can be adjusted according to the number of the child board 850 and 850a. Mounting holes 881 are formed between the left and right edges of the mother board 840 by cutting off some materials from the mother board 840. Several convexes 882 (not shown) are formed in the mounting holes 881 similarly to the convex 442 as depicted in figure 4. The mounting hole 881 and convex 882 between the left and right edges aligned with the slots 841 or convexes 842 at the both edges of the mother board 840. In this way, the guide and support apparatuses 820 with different length can be mounted via any two aligned convexes, for example, via two convexes 842 at the left and right edges of the mother board 840, via one convex 842 at one edge and one convex 882 between the two edges, and via two convex 882 between the two edges.

As shown in 8A, there is also a space formed between the guide and support apparatuses 820 with different length and the upper side of a mother board 840 when the different guide and support apparatus 820 is mounted on the mother board 840, such that the electronic components 872 can be mounted just under the guide and support apparatuses 820 with different length.

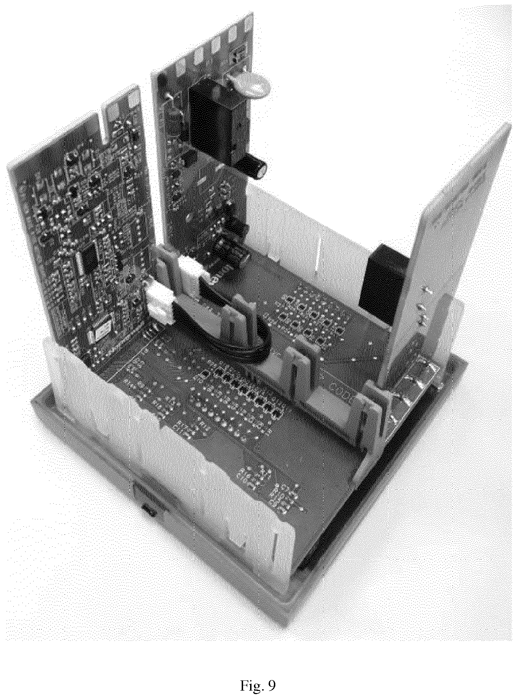

Figure 9 is a photo of the board matrix in a completed product according to the disclosure. As shown in figure 9, several child boards are mounted onto the mother board via the guide and support apparatus. The guide and support apparatus takes little on board space on both side of the print circuit board or the mother board, and it is easy to build up a board matrix via the compact and flexible design of the guide & lock portion.

### EXAMPLE EMBODIMENTS

Example 1 includes a guide and support apparatus comprising: a mounting portion, a support portion and a guide & lock portion, wherein the support portion extending perpendicularly to the guide & lock portion and ended at the mounting portion; the mounting portion extends downward from one or two ends of the support portion and comprises a lock structure; the guide & lock portion extends from the support portion vertically to a certain height.
Example 2 includes the guide and support apparatus according to example 1, wherein lock structure is below the support portion.
Example 3 includes the guide and support apparatus according to example 1 or 2, wherein the support portion comprises a top surface and a bottom surface, the lock structure is a hole formed in the support portion, and the peak in the hole is below the bottom surface.
Example 4 includes the guide and support apparatus according to any one of examples 1-3, wherein the guide & lock portion is arranged to guide a child board, and the mounting portion can be mounted to a mother board via the lock structure such that the guide and support apparatus is mounted to the mother board.
Example 5 includes the guide and support apparatus according to example 4, wherein the mother board and the child board are printed circuit board.
Example 6 includes the guide and support apparatus according to any one of examples 1-5, wherein when the guide and support apparatus is mounted to a mother board via the mounting portion, a space can be formed between the support portion and the mother board.
Example 7 includes the guide and support apparatus according to example 6, the space is between the bottom surface of support portion and the upper side of the mother board.
Example 8 includes the guide and support apparatus according to any one of examples 1-7, wherein the guide & lock portion includes first and second guide & lock portions, which all extend from the support portion up to a certain height, the first guide &lock portion is located on the front side and second guide &lock portion is located on the back side of the support portion.
Example 9 includes the guide and support apparatus according to example 8, the first and second guide &lock portion are back to back, parallel and aligned with each other.
Example 10 includes the guide and support apparatus according to example 8, the first and second guide &lock portion are back to back, parallel and interleaved with each other.
Example 11 includes the guide and support apparatus according to any one of examples 1-10, wherein the guide & lock portion comprises two ribs which extend up to the certain height from the support portion and connected by a lock portion on their top end, a slot extends between the two ribs and ends with the lock portion.
Example 12 includes the guide and support apparatus according to example 11, wherein the lock portion is positioned between the two ribs, and has a top surface and a front surface, wherein the front surface is lower than the front side of ribs such that a groove is defined by the front surface of the lock portion and the two ribs.
Example 13 includes the guide and support apparatus according to example 11, wherein the lock portion is positioned between the two ribs, and has a top surface and a front surface, where two projections are formed next to the lock portion such that a groove is defined by the front surface of the lock portion and the two projections.
Example 14 includes the guide and support apparatus according to example 12 or 13, wherein top surface of the lock portion is inclined relative to the front side of the ribs.
Example 15 includes a guide and support apparatus comprising a support portion and a guide & lock portion, the guide & lock portion extends from the support portion vertically to a certain height, wherein the guide & lock portion includes first and second guide & lock portions, wherein the guide & lock portion comprises two ribs which extend up to a certain height from the support portion and connected by a lock portion on their top end, a slot extends between the two ribs and ends with the lock portion.
Example 16 includes the guide and support apparatus according to example 15, wherein multiple guide & lock portions on the support portion are grouped into first guide &lock portion and second guide &lock portion, the first guide &lock portion is located on the front side and second guide &lock portion is located on the back side of the support portion.
Example 17 includes the guide and support apparatus according to example 16, the first and second guide &lock portion are back to back, parallel and aligned or interleaved with each other.
Example 18 includes the guide and support apparatus according to any of examples 15-17, wherein the lock portion is positioned between the two ribs, and has a top surface and a front surface, wherein the front surface is lower than the front side of ribs such that a groove is defined by the front surface of the lock portion and the two ribs.Example 19 includes the guide and support apparatus according to any of examples 15-17, wherein the lock portion is positioned between the two ribs, and has a top surface and a front surface, where two projections are formed next to the lock portion such that a groove is defined by the front surface of the lock portion and the two projections.Example 20 includes a board matrix comprising a child board, a mother board, and the guide and support apparatus according to any of the examples 1-19.Example 21 includes a board matrix according to the example 20, further comprising a cover, the cover parallel to the guide and support apparatus and mounted at the edge of mother board, wherein several trenches are formed such that the trenches are parallel to and aligned with the slot on the guide & lock portion.Example 22 includes a method for manufacturing a guide and support apparatus comprising: forming a support portion; forming a guide & lock portion which extends from the support portion to a certain height; and forming a mounting portion; wherein the support portion extending perpendicularly to the guide & lock portion and ended at the mounting portion; the mounting portion extends downward from one or two ends of the support portion and comprises a lock structure; the lock structure is below the support portion. Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims.

## Claims

1. A guide and support apparatus, comprising:
a mounting portion (221, 222, 421, 721), a support portion (223, 423, 723), and a guide & lock portion (224-225, 424-425, 524-525), wherein:
the support portion extends to the guide & lock portion and ends at the mounting portion, the said support portion comprises a top surface (227) and a bottom surface (228, 428); and the guide lock portion extends from the support portion to a certain height;
the mounting portion extends downward from one or two ends of the support portion and comprises a lock structure,
**characterized in that**
the said lock structure comprises a hole (226, 426, 726) formed in the mounting portion, and the hole in the mounting portion is below the level of the bottom surface of the support portion; and
the hole is configured to accept a convex portion (442, 842) of a mother board (440, 540, 740, 840) to mount and lock the guide and support apparatus onto the mother board.

2. The guide and support apparatus according to any one of claims 1, wherein:
the guide & lock portion is arranged to guide a child board (550, 650, 850, 850a), and
the mounting portion is configured to be mounted to a mother board (440, 540, 640, 740, 840) via the lock structure such that the guide and support apparatus is mounted to the mother board.

3. The guide and support apparatus according to any one of claims 1-2, wherein:
the guide & lock portion includes a first guide & lock portion (224, 424, 524) and a second guide & lock portion (225, 425, 525) that are located on a front side and a back side of the support portion, respectively, and
the first guide & lock portion and the second guide & lock portion are back to back, parallel, and aligned or interleaved with each other.

4. The guide and support apparatus according to any one of claims 1-3, wherein:
the guide & lock portion comprises two ribs (331) that extend up to the certain height from the support portion and that are connected by a lock portion (335) on their top ends, and
a slot (332) extends between the two ribs and ends with the lock portion.

5. The guide and support apparatus according to claim 4, wherein:
the lock portion is positioned between the two ribs and has a top surface (335a) and a front surface (335b),
the front surface is lower than front sides (331a) of the ribs such that a groove (333) is defined by the front surface of the lock portion and the two ribs, and
the top surface of the lock portion is inclined relative to the front sides of the ribs.

6. The guide and support apparatus according to claim 4, wherein:
the lock portion is positioned between the two ribs and has a top surface (335a) and a front surface (335b),
two projections (334) are formed next to the lock portion such that a groove (333) is defined by the front surface of the lock portion and the two projections, and
the top surface of the lock portion is inclined relative to the front side of the ribs.

7. The guide and support apparatus according to claim 1, wherein:
the guide & lock portion includes first and second guide & lock portions (224-225, 424-425, 524-525),
the guide & lock portion further comprises two ribs (331) that extend up to the certain height from the support portion and that are connected by a lock portion (335) on their top ends,
a slot (332) extends between the two ribs and ends with the lock portion,
the lock portion is positioned between the two ribs and has a top surface (335a) and a front surface (335b),
two projections (334) are formed next to the lock portion such that a groove (333) is defined by the front surface of the lock portion and the two projections, and
the top surface of the lock portion is inclined relative to the front side of the ribs.

8. A board matrix comprising a child board (550, 650, 850, 850a), a mother board (440, 540, 640, 740, 840), and the guide and support apparatus according to any of claims 1-7.

9. The board matrix according to claim 7, further comprising a cover (660), the cover parallel to the guide and support apparatus and mounted at an edge of the mother board, wherein several trenches (661) are formed such that the trenches are parallel to and aligned with a slot on the guide & lock portion.

10. A method for manufacturing a guide and support apparatus comprising:
forming a support portion (223, 423, 723), the said support portion comprises a top surface (227) and a bottom surface (228, 428);
forming a guide & lock portion (224-225, 424-425, 524-525) that extends from the support portion to a certain height; and
forming a mounting portion (221, 222, 421, 721) that extends downward from one or two ends of the support portion and comprises a lock structure (226, 426, 726),
**characterized in that**
the lock structure is below the support portion, the said lock structure comprises a hole (226, 426, 726) formed in the mounting portion, and the hole in the mounting portion is below the level of the bottom surface of the support portion;
wherein the support portion extends to the guide & lock portion and ends at the mounting portion;
the hole is configured to accept a convex portion (442, 842) of a mother board (440, 540, 740, 840) to mount and lock the guide and support apparatus onto the mother board.

## Patentansprüche

1. Führungs- und Stützvorrichtung, umfassend:
einen Befestigungsabschnitt (221, 222, 421, 721), einen Stützabschnitt (223, 423, 723) und einen Führungs- und Verriegelungsabschnitt (224-225, 424-425, 524-525), wobei:
sich der Stützabschnitt zu dem Führungs- und Verriegelungsabschnitt erstreckt und an dem Befestigungsabschnitt endet, wobei der Stützabschnitt eine obere Fläche (227) und eine untere Fläche (228, 428) umfasst und sich der Führungs- und Verriegelungsabschnitt von dem Stützabschnitt bis zu einer bestimmten Höhe erstreckt,
sich der Befestigungsabschnitt von einem oder zwei Enden des Stützabschnitts nach unten erstreckt und eine Verriegelungsstruktur umfasst,
**dadurch gekennzeichnet, dass** die Verriegelungsstruktur eine Öffnung (226, 426, 726) umfasst, die in dem Befestigungsabschnitt ausgebildet ist, und sich die Öffnung in dem Befestigungsabschnitt unterhalb der Höhe der unteren Fläche des Stützabschnitts befindet, und
die Öffnung dazu ausgelegt ist, einen konvexen Abschnitt (442, 842) einer Mutterplatine (440, 540, 740, 840) aufzunehmen, um die Führungs- und Stützvorrichtung auf der Mutterplatine zu befestigen und zu verriegeln.

2. Führungs- und Stützvorrichtung nach Anspruch 1, wobei:
der Führungs- und Verriegelungsabschnitt so angeordnet ist, dass er eine Tochterplatine (550, 650, 850, 850a) führt, und
der Befestigungsabschnitt dazu ausgelegt ist, über die Verriegelungsstruktur auf eine solche Weise an einer Mutterplatine (440, 540, 640, 740, 840) befestigt zu werden, dass die Führungs- und Stützvorrichtung an der Mutterplatine befestigt ist.

3. Führungs- und Stützvorrichtung nach einem der Ansprüche 1 bis 2, wobei:
der Führungs- und Verriegelungsabschnitt einen ersten Führungs- und Verriegelungsabschnitt (224, 424, 524) und einen zweiten Führungs- und Verriegelungsabschnitt (225, 425, 525) umfasst, die sich auf einer Vorderseite beziehungsweise einer Rückseite des Stützabschnitts befinden, und
der erste Führungs- und Verriegelungsabschnitt und der zweite Führungs- und Verriegelungsabschnitt Rücken an Rücken, parallel und in einer Linie ausgerichtet oder miteinander verschachtelt sind.

4. Führungs- und Stützvorrichtung nach einem der Ansprüche 1 bis 3, wobei:
der Führungs- und Verriegelungsabschnitt zwei Rippen (331) umfasst, die sich bis zu der bestimmten Höhe von dem Stützabschnitt erstrecken und die durch einen Verriegelungsabschnitt (335) an ihren oberen Enden verbunden sind, und
sich ein Schlitz (332) zwischen den zwei Rippen erstreckt und mit dem Verriegelungsabschnitt endet.

5. Führungs- und Stützvorrichtung nach Anspruch 4, wobei:
sich der Verriegelungsabschnitt zwischen den zwei Rippen befindet und eine obere Fläche (335a) und eine vordere Fläche (335b) aufweist,
die vordere Fläche auf eine solche Weise tiefer als die Vorderseiten (331a) der Rippen liegt, dass durch die vordere Fläche des Verriegelungsabschnitts und die zwei Rippen eine Rille (333) definiert ist, und
die obere Fläche des Verriegelungsabschnitts relativ zu den Vorderseiten der Rippen geneigt ist.

6. Führungs- und Stützvorrichtung nach Anspruch 4, wobei:
sich der Verriegelungsabschnitt zwischen den zwei Rippen befindet und eine obere Fläche (335a) und eine vordere Fläche (335b) aufweist,
zwei Vorsprünge (334) auf eine solche Weise neben dem Verriegelungsabschnitt ausgebildet ist, dass durch die vordere Fläche des Verriegelungsabschnitts und die zwei Vorsprünge eine Rille (333) definiert ist, und
die obere Fläche des Verriegelungsabschnitts relativ zu der Vorderseite der Rippen geneigt ist.

7. Führungs- und Stützvorrichtung nach Anspruch 1, wobei:
der Führungs- und Verriegelungsabschnitt einen ersten und einen zweiten Führungs- und Verriegelungsabschnitt (224-225, 424-425, 524-525) umfasst,
der Führungs- und Verriegelungsabschnitt ferner zwei Rippen (331) umfasst, die sich bis zu der bestimmten Höhe von dem Stützabschnitt erstrecken und die durch einen Verriegelungsabschnitt (335) an ihren oberen Enden verbunden sind,
sich ein Schlitz (332) zwischen den zwei Rippen erstreckt und mit dem Verriegelungsabschnitt endet,
sich der Verriegelungsabschnitt zwischen den zwei Rippen befindet und eine obere Fläche (335a) und eine vordere Fläche (335b) aufweist,
zwei Vorsprünge (334) auf eine solche Weise neben dem Verriegelungsabschnitt ausgebildet sind, dass durch die vordere Fläche des Verriegelungsabschnitts und die zwei Vorsprünge eine Rille (333) definiert ist, und
die obere Fläche des Verriegelungsabschnitts relativ zu der Vorderseite der Rippen geneigt ist.

8. Platinenmatrix, die eine Tochterplatine (550, 650, 850, 850a), eine Mutterplatine (440, 540, 640, 740, 840) und die Führungs- und Stützvorrichtung nach einem der Ansprüche 1 bis 7 umfasst.

9. Platinenmatrix nach Anspruch 7, die ferner eine Abdeckung (660) umfasst, wobei die Abdeckung parallel zu der Führungs- und Stützvorrichtung verläuft und an einem Rand der Mutterplatine befestigt ist, wobei mehrere Einschnitte (661) auf eine solche Weise ausgebildet sind, dass die Einschnitte parallel zu einem Schlitz auf dem Führungs- und Verriegelungsabschnitt verlaufen und in einer Linie mit demselben ausgerichtet sind.

10. Verfahren zum Herstellen einer Führungs- und Stützvorrichtung, umfassend:
Ausbilden eines Stützabschnitts (223, 423, 723), wobei der Stützabschnitt eine obere Fläche (227) und eine untere Fläche (228, 428) umfasst,
Ausbilden eines Führungs- und Verriegelungsabschnitts (224-225, 424-425, 524-525), der sich von dem Stützabschnitt bis zu einer bestimmten Höhe erstreckt, und
Ausbilden eines Befestigungsabschnitts (221, 222, 421, 721), der sich von einem oder zwei Enden des Stützabschnitts nach unten erstreckt und eine Verriegelungsstruktur (226, 426, 726) umfasst,
**dadurch gekennzeichnet, dass**
die Verriegelungsstruktur unterhalb des Stützabschnitts liegt, die Verriegelungsstruktur eine Öffnung (226, 426, 726) umfasst, die in dem Befestigungsabschnitt ausgebildet ist, und die Öffnung in dem Befestigungsabschnitt unterhalb der Höhe der unteren Fläche des Stützabschnitts liegt,
wobei sich der Stützabschnitt zu dem Führungs- und Verriegelungsabschnitt erstreckt und an dem Befestigungsabschnitt endet,
die Öffnung dazu ausgelegt ist, einen konvexen Abschnitt (442, 842) einer Mutterplatine (440, 540, 740, 840) aufzunehmen, um die Führungs- und Stützvorrichtung auf der Mutterplatine zu befestigen und zu verriegeln.

## Revendications

1. Appareil de guidage et de support, comprenant :
une partie de montage (221, 222, 421, 721), une partie de support (223, 423, 723) et une partie de guidage et de verrouillage (224-225, 424-425, 524-525), dans lequel :
la partie de support s'étend jusqu'à la partie de guidage et de verrouillage et se termine au niveau de la partie de montage, ladite partie de support comprend une surface supérieure (227) et une surface inférieure (228, 428) ; et la partie de guidage et de verrouillage s'étend à partir de la partie de support jusqu'à une certaine hauteur ;
la partie de montage s'étend vers le bas à partir d'une ou de deux extrémités de la partie de support et comprend une structure de verrouillage,
**caractérisé en ce que**
ladite structure de verrouillage comprend un trou (226, 426, 726) formé dans la partie de montage, et le trou dans la partie de montage est en dessous du niveau de la surface inférieure de la partie de support ; et
le trou est configuré pour recevoir une partie convexe (442, 842) d'une carte mère (440, 540, 740, 840) pour monter et verrouiller l'appareil de guidage et de support sur la carte mère.

2. Appareil de guidage et de support selon la revendication 1, dans lequel :
la partie de guidage et de verrouillage est agencée pour guider une carte fille (550, 650, 850, 850a), et
la partie de montage est configurée pour être montée sur une carte mère (440, 540, 640, 740, 840) par le biais de la structure de verrouillage de telle sorte que l'appareil de guidage et de support soit monté sur la carte mère.

3. Appareil de guidage et de support selon l'une quelconque des revendications 1 et 2, dans lequel :
la partie de guidage et de verrouillage comporte une première partie de guidage et de verrouillage (224, 424, 524) et une deuxième partie de guidage et de verrouillage (225, 425, 525) qui sont situées sur un côté avant et un côté arrière de la partie de support, respectivement, et
la première partie de guidage et de verrouillage et la deuxième partie de guidage et de verrouillages sont dos à dos, parallèles, et alignées ou imbriquées l'une dans l'autre.

4. Appareil de guidage et de support selon l'une quelconque des revendications 1 à 3, dans lequel :
la partie de guidage et de verrouillage comprend deux nervures (331) qui s'étendent jusqu'à la certaine hauteur à partir de la partie de support et qui sont reliées par une partie de verrouillage (335) sur leurs extrémités supérieures, et
une fente (332) s'étend entre les deux nervures et se termine par la partie de verrouillage.

5. Appareil de guidage et de support selon la revendication 4, dans lequel :
la partie de verrouillage est positionnée entre les deux nervures et comporte une surface supérieure (335a) et une surface avant (335b),
la surface avant est inférieure aux côtés avant (331a) des nervures de telle sorte qu'une rainure (333) soit définie par la surface avant de la partie de verrouillage et les deux nervures, et
la surface supérieure de la partie de verrouillage est inclinée par rapport aux côtés avant des nervures.

6. Appareil de guidage et de support selon la revendication 4, dans lequel :
la partie de verrouillage est positionnée entre les deux nervures et comporte une surface supérieure (335a) et une surface avant (335b),
deux saillies (334) sont formées près de la partie de verrouillage de telle sorte qu'une rainure (333) soit définie par la surface avant de la partie de verrouillage et les deux saillies, et
la surface supérieure de la partie de verrouillage est inclinée par rapport au côté avant des nervures.

7. Appareil de guidage et de support selon la revendication 1, dans lequel :
la partie de guidage et de verrouillage comporte des premières et deuxièmes parties de guidage et de verrouillage (224-225, 424-425, 524-525),
la partie de guidage et de verrouillage comprend en outre deux nervures (331) qui s'étendent jusqu'à la certaine hauteur à partir de la partie de support et qui sont reliées par une partie de verrouillage (335) sur leurs extrémités supérieures,
une fente (332) s'étend entre les deux nervures et se termine par la partie de verrouillage,
la partie de verrouillage est positionnée entre les deux nervures et comporte une surface supérieure (335a) et une surface avant (335b),
deux saillies (334) sont formées près de la partie de verrouillage de telle sorte qu'une rainure (333) soit définie par la surface avant de la partie de verrouillage et les deux saillies, et
la surface supérieure de la partie de verrouillage est inclinée par rapport au côté avant des nervures.

8. Matrice de cartes comprenant une carte fille (550, 650, 850, 850a), une carte mère (440, 540, 640, 740, 840), et l'appareil de guidage de support selon l'une quelconque des revendications 1 à 7.

9. Matrice de cartes selon la revendication 7, comprenant en outre un couvercle (660), le couvercle étant parallèle à l'appareil de guidage de support et monté au niveau d'un bord de la carte mère, dans laquelle plusieurs tranchées (661) sont formées de telle sorte que les tranchées sont parallèles à une fente sur la partie de guidage et de verrouillage et alignées avec cette fente.

10. Procédé de fabrication d'un appareil de guidage et de support comprenant :
la formation d'une partie de support (223, 423, 723), ladite partie de support comprenant une surface supérieure (227) et une surface inférieure (228, 428) ;
la formation d'une partie de guidage et de verrouillage (224-225, 424-425, 524-525) qui s'étend à partir de la partie de support jusqu'à une certaine hauteur ; et
la formation d'une partie de montage (221, 222, 421, 721) qui s'étend vers le bas à partir d'une ou de deux extrémités de la partie de support et comprend une structure de verrouillage (226, 426, 726),
**caractérisé en ce que**
la structure de verrouillage est en dessous de la partie de support, ladite structure de verrouillage comprend un trou (226, 426, 726) formé dans la partie de montage, et le trou dans la partie de montage est en dessous du niveau de la surface inférieure de la partie de support ;
la partie de support s'étendant jusqu'à la partie de guidage et de verrouillage et se terminant au niveau de la partie de montage ;
le trou est configuré pour recevoir une partie convexe (442, 842) d'une carte mère (440, 540, 740, 840) pour monter et verrouiller l'appareil de guidage et de support sur la carte mère.
